# EUROPÄISCHE PATENTSCHRIFT

(11) **EP 1 331 665 B1**
(45) Veröffentlichungstag und Bekanntmachung des Hinweises auf die Patenterteilung: **14.10.2009**
(21) Anmeldenummer: 02001846.1
(22) Anmeldetag: 26.01.2002
(51) Int. Cl.: H01L 23/473, H05K 7/20

(54) **Kühlvorrichtung**
Cooling apparatus
Dispositif de refroidissement

(43) Veröffentlichungstag der Anmeldung: 30.07.2003
(73) Patentinhaber: Danfoss Silicon Power GmbH, 24837 Schleswig (DE)
(72) Erfinder: Eisele, Ronald, 24229 Surendorf (DE); Olesen, Klaus, Kristen, DK-6400 Sonderborg (DK)
(74) Vertreter: Knoblauch, Andreas

(56) Entgegenhaltungen:
- WO-A-98/44307
- US-A- 5 239 443
- US-A- 5 269 372

## Beschreibung

Die Erfindung bezieht sich auf eine Kühlvorrichtung, insbesondere für elektronische Leistungsbauteile, mit einer wärmeleitenden Kühlplatte auf seiten der (oder des) zu kühlenden Mittel(s) und einer nahe bei der Kühlplatte angeordneten, plattenartigen Verteilereinrichtung für ein Kühlfluid, die auf ihrer der Kühlplatte zugekehrten Seite eine Vielzahl von Austrittsöffnungen für das Kühlfluid, die in einem Abstand von der Kühlplatte angeordnet und auf diese gerichtet sind, so daß eine weitgehend gleichmäßige Verteilung des Kühlfluids entlang der Unterseite der Kühlplatte erfolgt, und wenigstens eine Abführöffnung für das Kühlfluid aufweist.

Bei einer bekannten Kühlvorrichtung (FR-A-2 715 773) wird eine Kühlflüssigkeit aus als Düsen wirkenden Austrittsöffnungen der Verteilereinrichtung auf die Kühlplatte gerichtet. Außen auf der Kühlplatte ist ein Leistungsbauteil angeordnet, das aus mehreren Leistungs-Halbleiterbauelementen besteht. Jedem dieser Leistungs-Halbleiterbauelemente ist eine der Düsen auf der Unterseite der Kühlplatte zugeordnet. Die Verteilereinrichtung ist eine einteilige Platte, in der ein sich U-förmig verzweigender, als Bohrung ausgebildeter Zuführkanal für die Kühlflüssigkeit eingearbeitet ist. Die Kühlflüssigkeit wird über eine einzige Öffnung und einen als Bohrung ausgebildeten Abführkanal in der Mitte der Kühlplatte abgeführt. Die Herstellung der Verteilereinrichtung ist schwierig, weil sich die parallel zur Ebene der Kühlplatte erstreckenden Bohrungen nur schwierig ausbilden lassen. Da unter jedem Leistungs-Halbleiterbauelement eine Düse angeordnet ist, ist die Kühlvorrichtung nur für ein bestimmtes Leistungsbauteil passend. Für andere Formen von Leistungsbauteilen muß sie neu entworfen werden. Da ferner jedes Leistungs-Halbleiterbauelement durch nur einen Kühlflüssigkeitsstrahl gekühlt und die Kühlflüssigkeit durch eine gemeinsame Öffnung abgeführt wird, treten an der Kühlfläche der Leistungs-Halbleiterbauelemente verhältnismäßig große Temperaturgradienten auf. Sodann sind die Düsen alle am äußeren Rand des von der Kühlflüssigkeit durchströmten, zwischen der Kühlplatte und der Verteilerplatte liegenden Raums angeordnet. Daher strömt die Kühlflüssigkeit nicht symmetrisch in allen Richtungen von einer Düse zur zentralen Abführöffnung unter dem Leistungsbauteil entlang. Insbesondere längs der Ränder der Verteilerplatte tritt keine Strömung auf. Dort ist mithin keine ausreichende Wärmeabfuhr erreichbar.

In US-A-5 269 372 ist eine Kühlvorrichtung für elektrische Bauteile der eingangs genannten Art offenbart, wobei die Bauteile an einer Kühlplatte angeordnet sind.

Die Unterseite der Kühlplatte ist schachbrettartig ausgebildet, wobei die einzelnen Felder durch Kanäle voneinander abgegrenzt werden. An den Schnittpunkten der Kanäle sind Sackbohrungen vorgesehen, wobei über die eine Hälfte der Sackbohrungen das Kühlfluid zufließt und durch die andere Hälfte der Sackbohrungen wieder abfließt. Über eine plattenartige Verteilereinrichtung sind die Sackbohrungen mit einem gemeinsamen Zu- bzw. Abführanschluß verbunden. Dadurch ergibt sich eine schachbrettartige, ungleichmäßige Temperaturverteilung entlang der Kühlplatte und ein erhöhter Fertigungsaufwand.

Der Erfindung liegt die Aufgabe zugrunde, eine Kühlvorrichtung der eingangs genannten Art anzugeben, die für verschiedenste Formen von Leistungsbauteilen geeignet ist, eine gleichmäßige Kühlung auf der gesamten Kühlfläche der Kühlplatte und, sofern sie zur Kühlung von Leistungsbauteilen verwendet wird, für jedes Leistungsbauteil sicherstellt und einfacher herzustellen ist.

Erfindungsgemäß ist diese Aufgabe durch die Kühlvorrichtung gemäß dem Anspruch 1 gelöst, wobei die Verteilereinrichtung eine erste Platte, in der die ersten Austrittsöffnungen und eine Vielzahl von ersten Abführöffnungen gleichmäßig verteilt sind, eine zweite Platte, in der eine Vielzahl von zweiten Austrittsöffnungen verteilt sind, und eine dritte Platte aufweist, wobei die erste, zweite und dritte Platte übereinander angeordnet sind, wobei die zweite Platte zwischen der ersten Platte und der dritten Platte angeordnet ist, wobei die zweite Platte und die dritte Platte einen mit allen Austrittsöffnungen verbundenen Zuführkanal begrenzen und die erste Platte und die zweite Platte einen mit allen ersten Abführöffnungen verbundenen Abführkanal begrenzen, und wobei die Verteilereinrichtung Leitungen aufweist, die den Abführkanal durchqueren und die zweiten Austrittsöffnungen mit den ersten Austrittsöffnungen verbinden, und wobei die ersten Abführöffnungen direkt in den Abführkanal münden.

In einer alternativen Lösung gemäß dem Anspruch 2 ist vorgesehen, dass die Verteilereinrichtung eine erste Platte, in der die ersten Austrittsöffnungen und eine Vielzahl von ersten Abführöffnungen gleichmäßig verteilt sind, eine zweite Platte, in der eine Vielzahl von zweiten Abführöffnungen verteilt sind, und eine dritte Platte aufweist, wobei die erste, zweite und dritte Platte übereinander angeordnet sind, wobei die zweite Platte zwischen der ersten Platte und der dritten Platte angeordnet ist, wobei die erste Platte und die zweite Platte einen mit allen Austrittsöffnungen verbundenen Zuführkanal begrenzen und die zweite Platte und die dritte Platte einen mit allen ersten Abführöffnungen verbundenen Abführkanal begrenzen, und wobei die Verteilereinrichtung Leitungen aufweist, die den Zuführkanal durchqueren und die ersten Abführöffnungen mit den zweiten Abführöffnungen verbinden und wobei die ersten Austrittsöffnungen direkt an den Zuführkanal anschließen.

Aufgrund der Vielzahl gleichmäßig verteilter Austritts- und Abführöffnungen ist eine gleichmäßige Wärmeabfuhr und Kühlung auf der gesamten Kühlfläche der Kühlplatte sichergestellt, weitgehend unabhängig von der Form und Anzahl der gegebenenfalls zu kühlenden Leistungsbauteile. Entsprechendes gilt für ein zu kühlendes Fluid, wie ein Gas oder eine Flüssigkeit, die bzw. das mit der Kühlfläche der Kühlplatte in Berührung steht oder kommt. Da die Verteilereinrichtung sandwichartig aus mehreren Platten besteht, die den Zu- und Abführkanal begrenzen, ist die Herstellung der Verteilereinrichtung einfach: Die Formgebung der Kanäle kann auf einer Außenseite oder beiden Außenseiten einer Platte oder zweier Platten erfolgen, z.B. in einem entsprechenden Formwerkzeug. Gleichzeitig können, gegebenenfalls im selben Formwerkzeug, die erforderlichen Austritts- und Abführöffnungen in der ersten Platte ausgebildet werden.

Der Zuführkanal ist über Leitungen, die den Abführkanal durchqueren, mit den Austrittsöffnungen verbunden und die Abführöffnungen münden direkt in den Abführkanal. Diese Ausbildung ermöglicht auf einfache Weise die Verteilung des Kühlfluids an die Austrittsöffnungen und die Ausbildung der Abführöffnungen. Alternativ kann man die Austrittsöffnungen direkt an den Zuführkanal anschließen und die Abführöffnungen über den Zuführkanal durchquerende Leitungen mit dem Abführkanal verbinden.

Sodann können die Leitungen in Form von Rohrleitungen einstückig mit der zweiten Platte ausgebildet sein. Dies ermöglicht eine gemeinsame Herstellung der Rohrleitungen zusammen mit der zweiten Platte. Die Rohrleitungen können auf einfache Weise mit den Austrittsöffnungen durch eine Steckverbindung verbunden sein.

Die Rohrleitungen können in der alternativen Ausgestaltung einstückig mit der ersten Platte ausgebildet sein. Ferner können die Rohrleitungen durch eine Steckverbindung mit die zweite Platte durchsetzenden Löchern verbunden sein.

Vorzugsweise ist dafür gesorgt, daß die erste Platte in einer durch die Kühlplatte abgedeckten Öffnung einer Deckplatte eines Gehäuses eingesetzt, die zweite Platte in einer Öffnung einer Zwischenplatte des Gehäuses eingesetzt und die dritte Platte durch eine Bodenplatte des Gehäuses gebildet ist. Bei dieser Ausbildung werden der Zuführkanal und der Abführkanal auf einfache Weise seitlich durch die Gehäuseplatten begrenzt, wobei die Bodenplatte des Gehäuses gleichzeitig einen der Kanäle auf seiner Unterseite begrenzt.

Alternativ kann die dritte Platte mit auf eine zweite Kühlplatte gerichteten Austrittsöffnungen versehen sein, die über den Abführkanal und die zweite Platte durchquerende Rohrleitungen mit dem Zuführkanal verbunden sind, während die dritte Platte zum Abführkanal führende Abführöffnungen aufweist. Dadurch verdoppelt sich durch die Hinzunahme nur einer weiteren Platte, der zweiten Kühlplatte, die Kühlfläche der Kühlvorrichtung.

Vorzugsweise ist dafür gesorgt, daß jede Kühlplatte aus Metall besteht und wenigstens die zweite Platte und die dritte Platte sowie die Rohrleitungen aus wärmeisolierendem, thermoplastischen Kunststoff bestehen. Hierbei sorgen die Metallplatten für eine gute Wärmeableitung und die wärmeisolierenden Platten und Rohrleitungen für eine gegenseitige Wärmeisolation des Zuführkanals und des Abführkanals. Die Kunststoffplatten und -rohrleitungen lassen sich ferner auf einfache Weise herstellen, z.B. im Spritzgußverfahren.

Eine vorteilhafte Ausbildung kann darin bestehen, daß zwischen der ersten Platte und der zweiten Platte, an diesen anliegend, eine vierte Platte angeordnet ist, in der ein etwa kammförmiger erster Durchbruch den Zuführkanal seitlich begrenzt, daß zwischen der zweiten Platte und der dritten Platte, an diesen anliegend, eine fünfte Platte angeordnet ist, in der ein etwa kammförmiger zweiter Durchbruch den Abführkanal seitlich begrenzt, daß jedem einer Kammzinke entsprechenden Zweig des ersten Durchbruchs wenigstens eine Gruppe von Austrittsöffnungen der ersten Platte zugeordnet ist, daß jede zwischen benachbarte Zweige des ersten Durchbruchs ragende Zunge der vierten Platte eine Gruppe von Abführöffnungen aufweist, die jeweils mit einer Abführöffnung in der ersten Platte und einer Abführöffnung in der zweiten Platte fluchten, und daß jede Gruppe von Abführöffnungen der zweiten Platte jeweils einem einer Kammzinke entsprechenden Zweig des zweiten Durchbruchs zugeordnet ist. Diese Ausbildung der Kühlvorrichtung ist plattenartig flach und kompakt. Ausgeprägte Rohrleitungen können entfallen. In den Platten brauchen nur Löcher oder Durchbrüche ausgebildet zu werden.

Ferner kann hierbei dafür gesorgt sein, daß zwischen der Kühlplatte und der ersten Platte, an diesen anliegend, eine sechste Platte angeordnet ist, in der Löcher ausgebildet sind, und daß über jedes dieser Löcher jeweils wenigstens eine der Gruppen von Austrittsöffnungen und Abführöffnungen der ersten Platte mit der Kühlplatte in Verbindung steht. In diesen Löchern, von denen jedes größer als die Gesamtdurchtrittsfläche wenigstens einer Gruppe von Austrittsöffnungen und einer Gruppe von Abführöffnungen in der ersten Platte ist, kann sich das aus den Austrittsöffnungen austretende Kühlfluid großflächig und gleichmäßig verteilen und mit der Kühlplatte in Berührung kommen, so daß, wenn auf der Außenseite der Kühlplatte über einem der Löcher ein Leistungsbauteil angebracht oder an der Außenseite der Kühlplatte ein zu kühlendes Fluid entlanggeführt wird, eine gleichmäßige Kühlung des zu kühlenden Mittels (Leistungsbauteil oder zu kühlendes Fluid) sichergestellt ist.

Eine Weiterbildung kann darin bestehen, daß der erste Durchbruch über in der zweiten, dritten und fünften Platte ausgebildete, miteinander fluchtende Löcher mit einem Einlaßanschluß und der zweite Durchbruch über ein in der dritten Platte ausgebildetes Loch mit einem Auslaßanschluß verbunden ist. Auch für die Verbindung von Zu- und Abführkanal mit dem Einlaß- bzw. Auslaßanschluß sind mithin in den Platten nur Löcher erforderlich.

Vorzugsweise sind die Platten dicht miteinander verbunden. Statt eines gasförmigen Kühlfluids, wie Luft, kann dann auch eine Kühlflüssigkeit verwendet werden, ohne daß die Gefahr einer Beeinträchtigung der zu kühlenden Bauteile und/oder einer Verschmutzung durch in unerwünschter Weise austretende Kühlflüssigkeit besteht.

Wenigstens die erste bis fünfte Platte kann aus Kunststoff oder Metall und die Kühlplatte aus Metall bestehen. Auch bei dieser plattenartigen Kühlvorrichtung lassen sich die Platten daher auf einfache Weise herstellen.

Die Erfindung und ihre Weiterbildungen werden nachstehend anhand der Zeichnungen bevorzugter Ausführungsbeispiele näher beschrieben. Darin stellen dar:
- Fig. 1: eine perspektivische Draufsicht auf ein erstes Ausführungsbeispiel einer erfindungsgemäßen Kühlvorrichtung mit darauf angebrachten, zu kühlenden elektronischen Leistungsbauteilen,
- Fig. 2: einen Ausschnitt des Schnitts I-I der Fig. 1 in vergrößertem Maßstab,
- Fig. 3: einen vergrößerten Ausschnitt der Schnittansicht nach Fig. 2,
- Fig. 4: zwei Platten einer Kühlfluid-Verteilereinrichtung der Kühlvorrichtung nach den Fig. 1 bis 3 in perspektivischer Explosionsdarstellung,
- Fig. 5: eine perspektivische Explosionsdarstellung von Gehäuseplatten der Kühlvorrichtung nach den Fig. 1 und 2,
- Fig. 6: eine perspektivische Schnittansicht eines Teils eines zweiten Ausführungsbeispiels einer erfindungsgemäßen Kühlvorrichtung,
- Fig. 7: eine gegenüber dem ersten und zweiten Ausführungsbeispiel etwas abgewandelte Kühlfluid-Verteilereinrichtung,
- Fig. 8: eine perspektivische Explosionsdarstellung der in Fig. 7 ausschnittweise dargestellten Verteilereinrichtung,
- Fig. 9: eine Explosionsdarstellung eines weiteren Ausführungsbeispiels einer erfindungsgemäßen Kühlvorrichtung und
- Fig. 10: eine perspektivische Schnittansicht noch eines weiteren Ausführungsbeispiels einer erfindungsgemäßen Kühlvorrichtung.

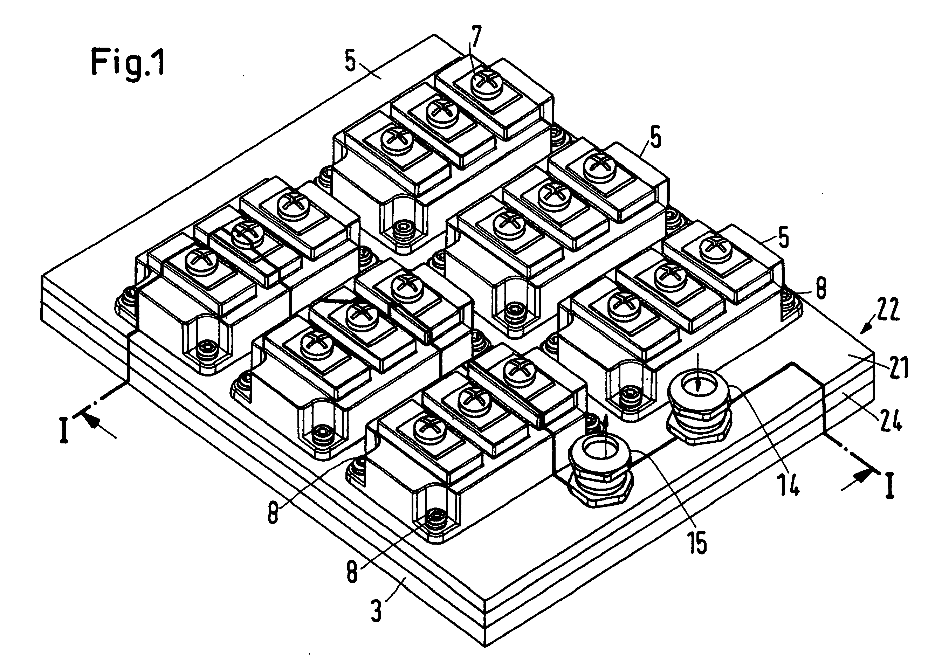

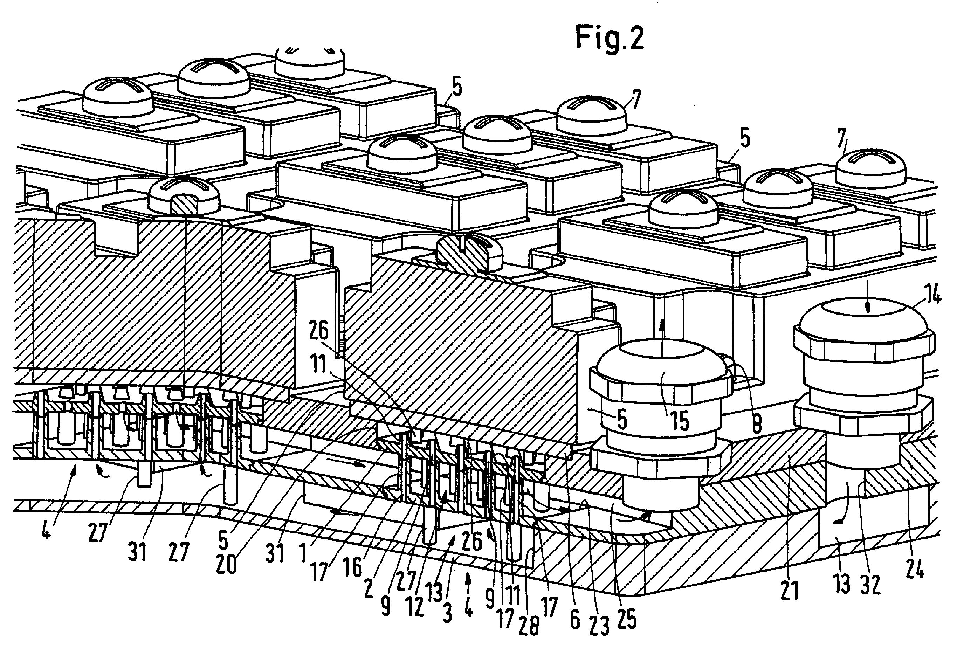

Die Kühlvorrichtung nach den Fig. 1 bis 5 enthält wenigstens eine erste Platte 1, eine zweite Platte 2 und eine dritte Platte 3, die gemeinsam jeweils eine Verteilereinrichtung 4 für ein Kühlfluid zum Kühlen eines elektronischen Leistungsbauteils 5 über eine Kühlplatte 6 aus Metall bilden. Die Kühlvorrichtung dient zum gleichzeitigen Kühlen mehrerer elektronischer Leistungsbauteile 5, sogenannter Leistungsmodule, die jeweils mehrere Leistungs-Halbleiterbauelemente, sogenannte "Chips", enthalten können und mit Klemmanschlüssen 7 versehen sind. Die Leistungsbauteile 5 sind jeweils auf einer der Kühlplatten 6 (Fig. 2) mittels Schrauben 8 befestigt.

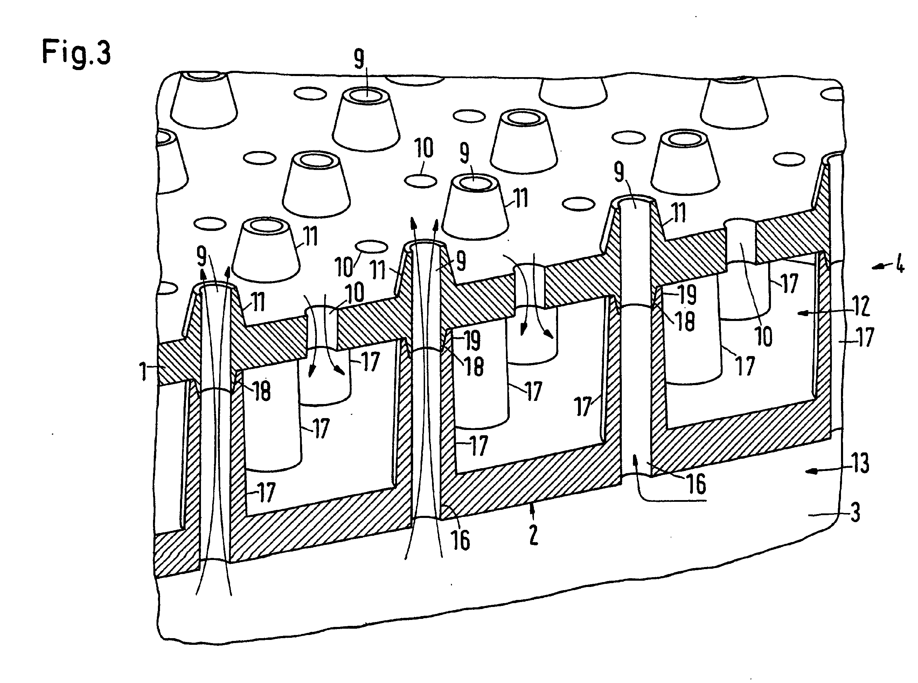

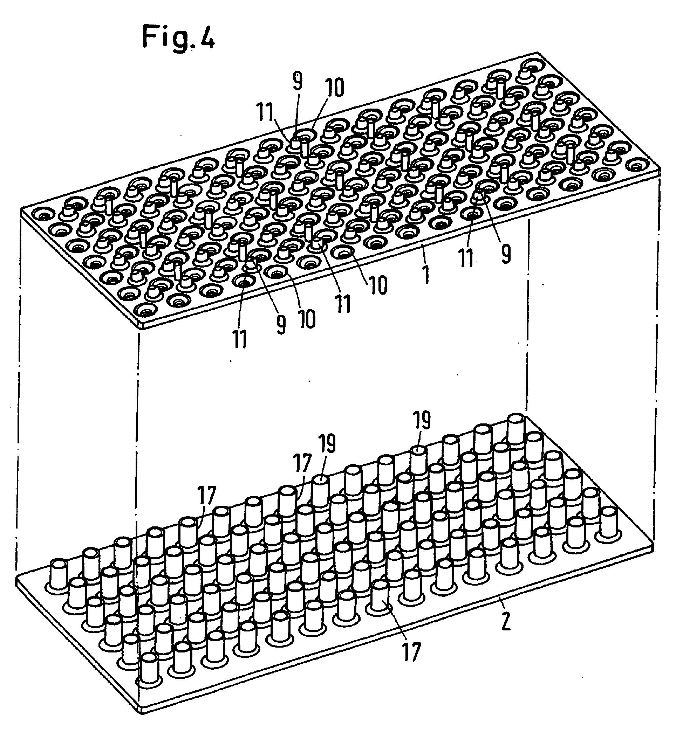

Die bzw. jede Platte 1 hat eine Vielzahl gleichmäßig über ihre Fläche verteilter Austrittsöffnungen 9 und Abführöffnungen 10 (Fig. 3 und 4). An die Austrittsöffnungen 9 schließen sich außen kegelförmige Stutzen an, die auf die Kühlplatte 6 gerichtet sind. Die Abführöffnungen 10 sind als einfache Bohrungen in der Platte 1 ausgebildet und münden direkt in einen Abführkanal 12, der in der Lage nach den Fig. 1 bis 3 oben durch die Platte 1 und unten durch die Platte 2 begrenzt ist. Die zweite Platte 2 begrenzt zwischen sich und der dritten Platte 3 einen Zuführkanal 13. Der Zuführkanal 13 ist mit einem Einlaßanschluß 14 und der Abführkanal 12 mit einem Auslaßanschluß 15 für das Kühlfluid verbunden.

Der Zuführkanal 13 ist über in der Platte 2 ausgebildete Öffnungen 16 und an diese einstückig angeformte Rohrleitungen 17, die den Abführkanal 12 zwischen den Platten 2 und 3 durchqueren, mit den Austrittsöffnungen 9 durch eine Steckverbindung verbunden. Zur Ausbildung dieser Steckverbindung sind an der Unterseite der Platte 1 jeweils mit einer der Austrittsöffnungen 9 fluchtende, außen konische Anschlußstutzen 18 einstückig angeformt und jeweils in einen innen entsprechend konischen Endabschnitt 19 der Rohrleitungen 17 passend eingesetzt und vorzugsweise stoffschlüssig, z.B. durch Kleben oder Schweißen, darin befestigt (Fig. 3). Von der stoffschlüssigen Verbindung kann abgesehen werden, wenn es sich bei dem Kühlfluid um ein Gas, z.B. Luft, und nicht um eine Flüssigkeit, z.B. Wasser, handelt.

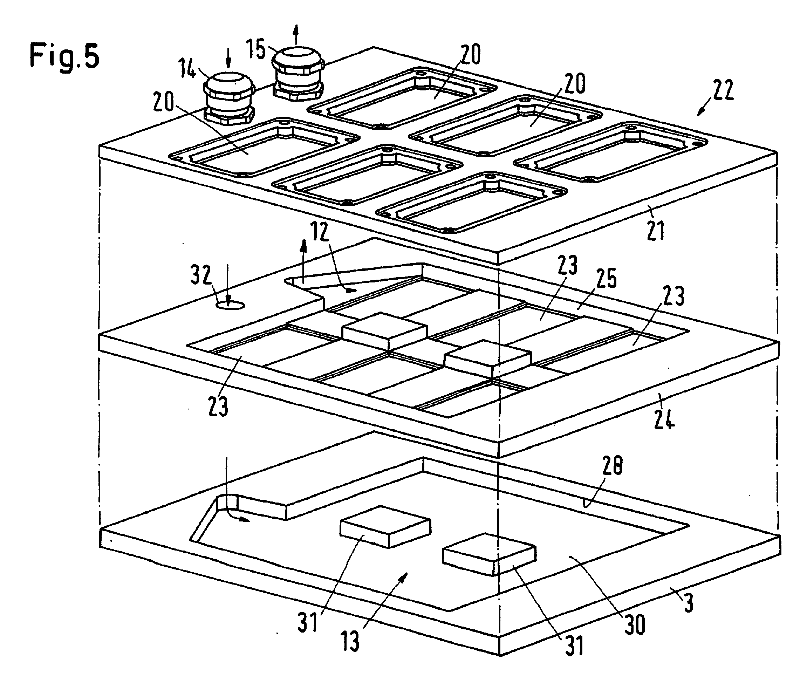

Jede erste Platte 1 ist jeweils in einer durch die Kühlplatte 6 abgedeckten Öffnung 20 einer Deckplatte 21 eines Gehäuses 22 eingesetzt, siehe insbesondere Fig. 1, 2 und 5. Jede zweite Platte 2 ist jeweils in einer Öffnung 23 einer Zwischenplatte 24 des Gehäuses 22 eingesetzt, siehe insbesondere Fig. 1, 2 und 5. Die dritte Platte 3 ist durch eine Bodenplatte des Gehäuses 22 gebildet. Die Deckplatte 21 begrenzt dabei mit dem Rand jeder Öffnung 20 jeweils den Umfang einer Kühlkammer, die oben und unten durch die Kühlplatte 6 und die Platte 2 begrenzt und jeweils einem der Leistungsbauteile 5 zugeordnet ist. Die Zwischenplatte 24 begrenzt dabei mit je einem Abschnitt einer Umrandung 25 einer Aussparung einen Teil des Umfangs der Öffnungen 23 und des Abführkanals 12. Auf der Platte 1 sind ferner zylindrische Stützen 26 (Fig. 2 und 4, in Fig. 3 nicht dargestellt) angeformt, die an der Unterseite der betreffenden Kühlplatte 6 anliegen, um eine Durchbiegung der Platte 1 nach oben zu verhindern. Dabei verhindern die Rohrleitungen 17 gleichzeitig eine Durchbiegung der Platte 2 nach oben und an der Unterseite der Platte 2 angeformte zylindrische Stützen 27 (Fig. 2), die in den Fig. 3 und 4 nicht sichtbar sind, eine Durchbiegung der Platte 2 nach unten. Die Platte 3 begrenzt ebenfalls mit einer Umrandung 28 (Fig. 2 und 5) und am Boden 30 der Aussparung ausgebildeten quaderförmigen Vorsprüngen 31 die Seiten des Zuführkanals 13. Der Einlaßanschluß 14 ist über ein Loch 32 (Fig. 2 und 5) in der Zwischenplatte 24 mit dem Zuführkanal 13 und der Abführkanal 12 direkt mit dem Auslaßanschluß 15 verbunden.

Das Kühlfluid strömt daher in Richtung der eingezeichneten Strömungspfeile vom Einlaßanschluß 14 durch den Zuführkanal 13, verteilt sich von dort über die Öffnungen 16 in der Platte 2 und über die Rohrleitungen 17 in die Austrittsöffnungen der Platte 1, dringt von dort in weitgehend gleichmäßiger Verteilung bis an die Unterseite jeder Kühlplatte 6 und strömt, unter Abführung der Wärme und gleichmäßiger Abkühlung der Leistungsbauteile 5, durch die Abführöffnungen 10 der Platte 1 in den Abführkanal 12 und von dort zum Auslaßanschluß 15. Die Kühlvorrichtung ist sehr flach bzw. dünn, wobei die Gesamtdicke der Platten 3, 21 und 24 weniger als 10 mm beträgt. Die Platten 3, 21 und 24 bestehen vorzugsweise aus wärmeisolierendem, thermoplastischen Kunststoff und sind dicht miteinander, vorzugsweise stoffschlüssig, z.B. durch Verkleben oder Verschweißen, verbunden. Sie können aber auch aus Metall bestehen. In beiden Fällen läßt sich die Kühlvorrichtung auf einfache Weise herstellen. Die Anzahl der Leistungsbauteile 5 und dementsprechend die der Verteilereinrichtungen 4 ist nicht auf die dargestellte Anzahl sechs beschränkt. Sie kann größer oder kleiner sein, z.B. auch nur gleich eins.

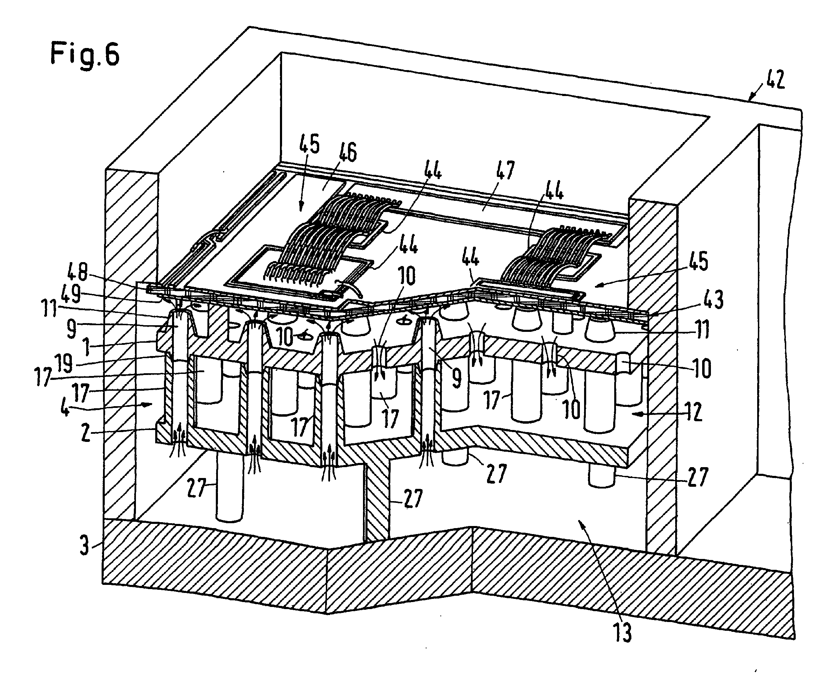

Das Ausführungsbeispiel nach Fig. 6 unterscheidet sich von dem nach den Fig. 1 bis 5 im wesentlichen nur darin, daß die Verteilereinrichtungen 4, von denen nur eine dargestellt ist, jeweils in einer eigenen Kammer eines Gehäuses 42 angeordnet und auf der Kühlplatte 43 aus mehreren Leistungs-Halbleiterbauelementen 44, hier jeweils zwei, bestehende Leistungsbauelemente 45 befestigt sind. Die Kühlplatte 43 ist verhältnismäßig dünn und besteht in der Mitte aus einer Schicht 48 aus elektrisch isolierendem Keramikmaterial, wie AlSiC, mit guter Wärmeleitfähigkeit, deren Oberseite Kupferschichten 46 und 47 zur Stromversorgung und deren Unterseite eine dünne Kupferschicht 49 zum Ausgleich der unterschiedlichen Wärmedehnungskoeffizienten der Schichten 46, 47 und 48 aufweist. Die Zu- und Abführung des Kühlfluids erfolgt wiederum über am Gehäuse 42 vorgesehene, nicht dargestellte Ein- und Auslaßanschlüsse. Das Gehäuse 42 besteht aus wärmeisolierendem Kunststoff. Die Platte 3 kann aus Metall oder Kunststoff bestehen. Die Strömungsrichtung des Kühlfluids ist wiederum durch Strömungspfeile angedeutet.

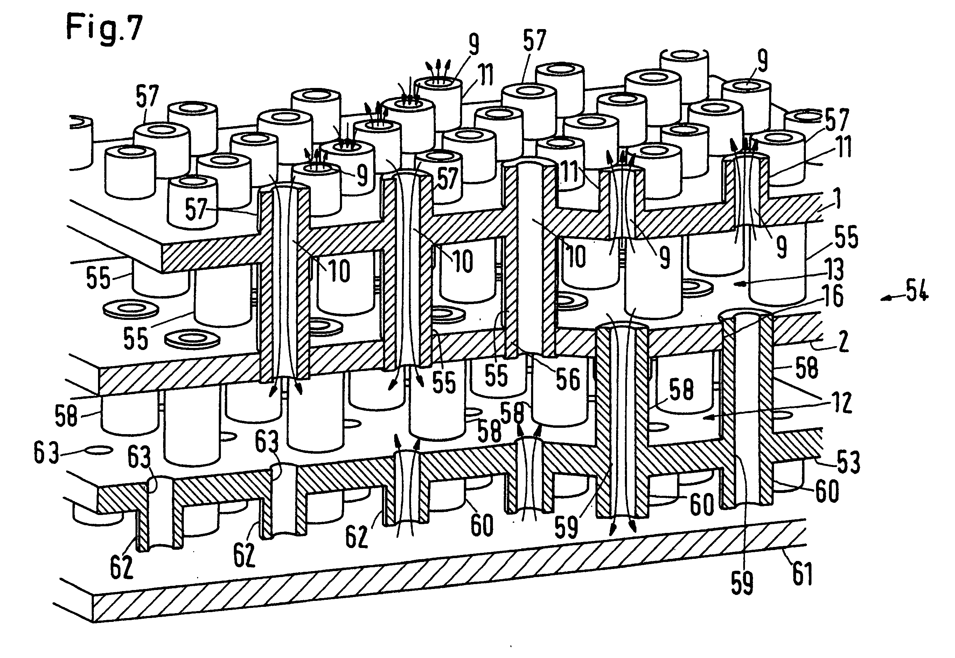

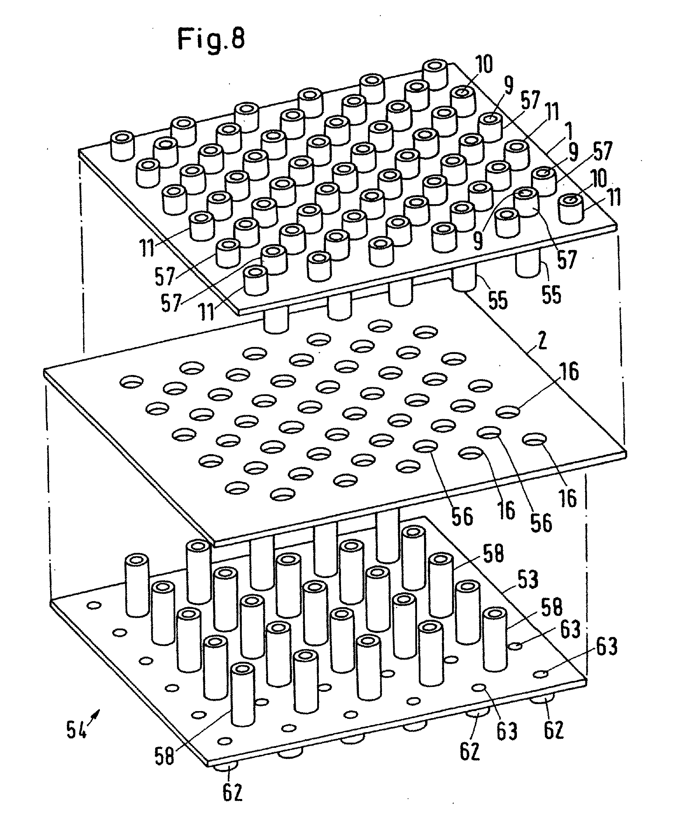

Fig. 7 zeigt einen Ausschnitt und Fig. 8 eine Explosionsdarstellung einer abgewandelten Verteilereinrichtung 54 für das Kühlfluid, die auch in den Kühlvorrichtungen nach den Fig. 1 bis 6 anstelle der Verteilereinrichtung 4 verwendet werden kann. Bei der Verteilereinrichtung 54 nach Fig. 7 sind die den Zuführkanal 13 durchquerenden Rohrleitungen 55 einstückig mit der ersten Platte 1 ausgebildet. Die Rohrleitungen 55 dienen der Abführung des Kühlfluids aus dem Raum zwischen der in Fig. 7 nicht dargestellten Kühlplatte 6 (Fig. 2) oder Kühlplatte 43 (Fig. 6) und der ersten Platte 1 in den Abführkanal 12. Dabei sind die Rohrleitungen 55 mit Löchern 56 in der zweiten Platte 2 zusammengesteckt und vorzugsweise stoffschlüssig mit diesen verbunden. Ferner sind nicht nur die Austrittsöffnungen 9, sondern auch die Abführöffnungen 10 auf der der nicht dargestellten Kühlplatte zugekehrten Seite der ersten Platte 1 mit Stutzen 11 bzw. 57 verbunden, die jeweils nur bis in die Nähe der nicht dargestellten Kühlplatte reichen, d.h. einen Abstand von dieser Kühlplatte einhalten. In die Öffnungen 16 der zweiten Platte 2 sind weitere Rohrleitungen 58 eingesetzt, die den Abführkanal 12 durchqueren und einstückig mit Abführöffnungen 59 in der dritten Platte 53 verbunden sind. An diese Abführöffnungen 59 schließen sich außerdem einstückig mit der dritten Platte 53 ausgebildete Stutzen 60 an. Die Stutzen 60 reichen bis in die Nähe einer zweiten Kühlplatte 61 und richten das aus dem Zuführkanal 13 über die Rohrleitungen 58 zugeführte Kühlfluid auf die zweite Kühlplatte 61. An der Unterseite der zweiten Kühlplatte 61 können weitere Leistungsbauteile, wie die Leistungsbauteile 5 oder 45, angebracht sein. Die Kühlplatte 61 kann ebenso wie die Kühlplatte 6 oder die Kühlplatte 43 ausgebildet sein. Das Kühlfluid wird über der Kühlplatte 61 zugekehrte, mit der dritten Platte 53 einstückig ausgebildete Stutzen 62, die sich an Abführöffnungen 63 in der dritten Platte 53 anschließen, in den Abführkanal 12 zurückgeleitet. Die Strömungsrichtung des Kühlfluids ist wieder durch Strömungspfeile angedeutet.

Bei dieser Ausführung der Verteilereinrichtung 54 ist die Gesamtkühlfläche, ohne den Raumbedarf wesentlich zu vergrößern, doppelt so groß wie bei den vorherigen Ausführungsbeispielen.

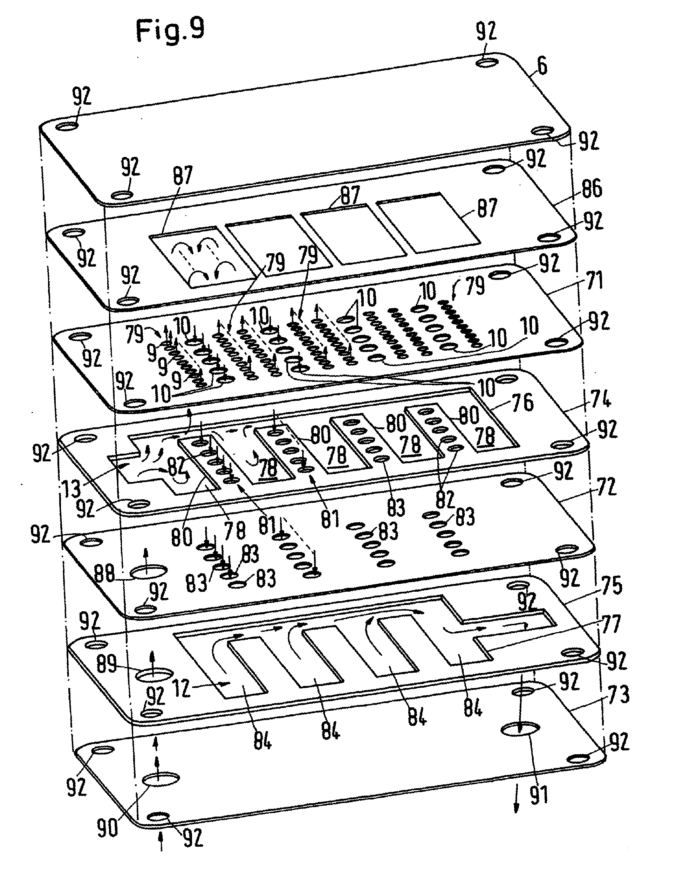

Fig. 9 stellt ein weiteres Ausführungsbeispiel der Erfindung dar, das einen Kühlteil einer Kühlvorrichtung oder allein eine erfindungsgemäße Kühlvorrichtung bilden kann. Diese Kühlvorrichtung bzw. das Kühlteil enthält wiederum eine erste Platte 71, eine zweite Platte 72 und eine dritte Platte 73. Zwischen der ersten Platte 71 und der zweiten Platte 72, an diesen anliegend, ist eine vierte Platte 74 angeordnet. In der vierten Platte 74 ist ein etwa kammförmiger erster Durchbruch 76 ausgebildet, der den Zuführkanal 13 seitlich begrenzt, während die Platten 71 und 72 ihn oben und unten begrenzen. Zwischen der zweiten Platte 72 und der dritten Platte 73, an diesen anliegend, ist eine fünfte Platte 75 angeordnet, in der ein zweiter, etwa kammartiger Durchbruch 77 ausgebildet ist. Dieser Durchbruch 77 begrenzt den Abführkanal 12 seitlich, während die Platten 72 und 73 ihn oben und unten begrenzen. Jedem einer Kammzinke entsprechenden Zweig 78 des ersten Durchbruchs 76 ist wenigstens eine in einer Reihe angeordnete Gruppe 79 von Austrittsöffnungen 9 zugeordnet. Jede zwischen benachbarte Zweige 78 des ersten Durchbruchs 76 ragende Zunge 80 der vierten Platte 74 enthält eine Gruppe 81 von Abführöffnungen 82, die jeweils mit einer Abführöffnung 10 in der ersten Platte 71 und einer Abführöffnung 83 in der zweiten Platte 72 fluchten. Jede in einer Reihe liegende Gruppe von Abführöffnungen 83 der zweiten Platte 72 ist jeweils einem einer Kammzinke entsprechenden Zweig 84 des zweiten Durchbruchs 77 zugeordnet.

Zwischen der Kühlplatte 6 und der ersten Platte 71, an diesen anliegend, ist eine sechste Platte 86 angeordnet, in der Löcher 87 ausgebildet sind. Über jedes dieser Löcher 87 steht jeweils wenigstens eine der Gruppen 79 von Austrittsöffnungen 9, hier zwei Gruppen 79, und eine Gruppe von Abführöffnungen 10, hier die zwischen zwei benachbarten Gruppen 79 von Austrittsöffnungen 9 liegende Gruppe von Abführöffnungen 10, mit der Kühlplatte 6 in Verbindung. Der erste Durchbruch 76 ist über in der zweiten, dritten und fünften Platte 72, 73, 75 ausgebildete, miteinander fluchtende Löcher 88, 89 und 90 mit einem (nicht dargestellten) Einlaßanschluß und der zweite Durchbruch 77 über ein in der dritten Platte 73 ausgebildetes Loch 91 mit einem (nicht dargestellten) Auslaßanschluß verbunden. Die Platten 6, 71-75 und 86 sind alle dicht miteinander verbunden, hier mittels Schrauben, die durch Löcher 92 in den Platten 6, 71-75, 86 hindurchgeführt sind. Zusätzlich oder statt dessen können die Platten 6, 71-75, 86 miteinander verklebt oder verschweißt sein.

Die Kühlplatte 6 besteht wiederum aus Metall, kann aber auch wie die Kühlplatte 43 in Fig. 6 ausgebildet sein.

Der in Fig. 9 dargestellte Kühlteil kann wiederum allein oder zu mehreren in einem Gehäuse eingebaut und auf der Kühlplatte 6 mit zu kühlenden Leistungsbauteilen 5 versehen oder mit der Kühlplatte 6 mit einem zu kühlenden Fluid in Berührung gebracht werden.

Insgesamt hat der Kühlteil einen sehr flachen, kompakten und einfach herzustellenden Aufbau, wobei die Platten 71-75 und 86 alle aus wärmeisolierendem thermoplastischen Kunststoff hergestellt sein können. Es ist aber auch möglich, nicht nur die Kühlplatte 6, sondern auch die Platte 86 und die Platten 72, 73 und 75 oder alle Platten 6, 71-75 und 86 aus Metall herzustellen.

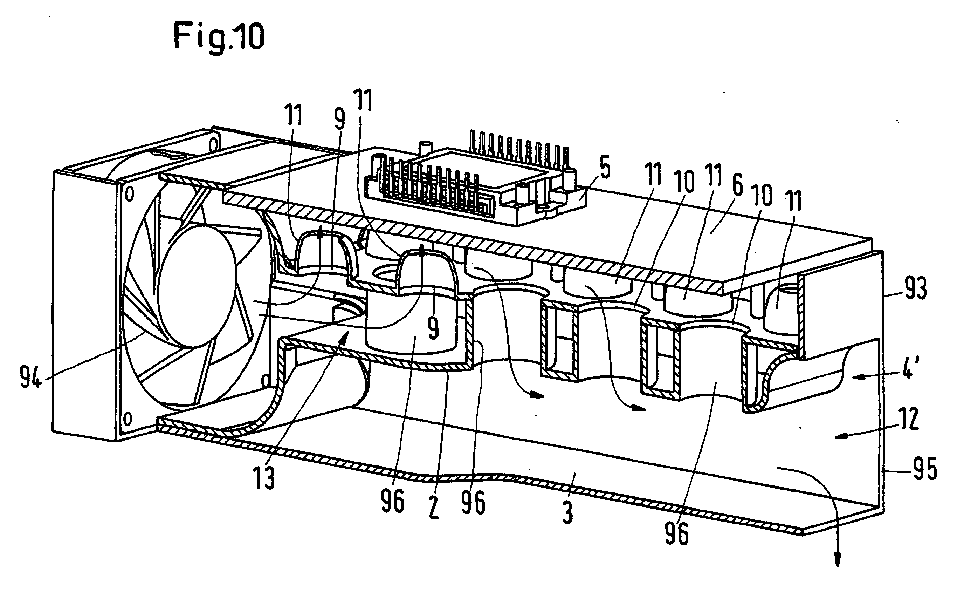

Fig. 10 stellt ein weiteres Ausführungsbeispiel einer erfindungsgemäßen Kühlvorrichtung dar, bei dem auf einer Kühlplatte 6, die zugleich die Deckplatte eines Gehäuses 93 bildet, wenigstens ein elektronisches Leistungsbauteil 5 befestigt ist. Unter der Kühlplatte 6 ist eine der Verteilereinrichtung 4 nach Fig. 2 und 3 weitgehend - bis auf die Vertauschung von Zu- und Abführkanal und damit eine Umkehr der Strömungsrichtung - entsprechende Verteilereinrichtung 4' angeordnet. Durch ein Gebläse 94 wird Luft oder ein anderes Gas als Kühlfluid am einen Ende des Gehäuses 93 in den Zuführkanal 13 geblasen und über den Abführkanal 12 durch eine Öffnung 95 am anderen Ende des Gehäuses 93 unmittelbar ins Freie geblasen. In diesem Fall schließen sich die Austrittsöffnungen 9 direkt am Zuführkanal 13 an, während die Abführöffnungen 10 über den Zuführkanal 13 durchquerende Rohrleitungen 96 mit dem Abführkanal 12 verbunden sind. Prinzipiell ist daher lediglich die Strömungsrichtung des Kühlfluids gegenüber der nach dem ersten Ausführungsbeispiel umgekehrt.

## Patentansprüche

1. Kühlvorrichtung für elektronische Leistungsbauteile (5, 45), mit einer wärmeleitenden, bei der Benutzung der Kühlvorrichtung mit dem elektronischen Leistungsbauteil bzw. einem zu kühlenden Fluid in wärmeleitenden Kontakt stehenden Kühlplatte (6, 43) und einer auf der dem elektronischen Leistungsbauteil bzw. dem zu kühlenden Fluid abgewandten Seite der Kühlplatte (6, 43) angeordneten, plattenartigen Verteilereinrichtung (4) für ein Kühlfluid, die auf ihrer der Kühlplatte (6, 43) zugekehrten Seite eine Vielzahl von ersten Austrittsöffnungen (9) für das Kühlfluid, die in einem Abstand von der Kühlplatte (6, 43) angeordnet und auf diese gerichtet sind und wenigstens eine erste Abführöffnung (10) für das Kühlfluid aufweist, wobei die Verteilereinrichtung (4) eine erste Platte (1), in der die ersten Austrittsöffnungen (9) und eine Vielzahl von ersten Abführöffnungen (10) gleichmäßig verteilt sind, eine zweite Platte (2), in der eine Vielzahl von zweiten Austrittsöffnungen (16) verteilt sind, und eine dritte Platte (3) aufweist, wobei die erste, zweite und dritte Platte übereinander angeordnet sind, wobei die zweite Platte (2) zwischen der ersten Platte (1) und der dritten Platte (3) angeordnet ist, wobei die zweite Platte (2) und die dritte Platte (3) einen mit allen ersten Austrittsöffnungen (9) verbundenen Zuführkanal (13) begrenzen und die erste Platte (1) und die zweite Platte (2) einen mit allen ersten Abführöffnungen (10) verbundenen Abführkanal (12) begrenzen, und wobei die Verteilereinrichtung (4) Leitungen (17) aufweist, die den Abführkanal (12) durchqueren und die zweiten Austrittsöffnungen (16) mit den ersten Austrittsöffnungen (9) verbinden, und wobei die ersten Abführöffnungen (10) direkt in den Abführkanal (12) münden.

2. Kühlvorrichtung für elektronische Leistungsbauteile (5, 45), mit einer wärmeleitenden, bei der Benutzung der Kühlvorrichtung mit dem elektronischen Leistungsbauteil bzw. einem zu kühlenden Fluid in wärmeleitenden Kontakt stehenden Kühlplatte (6, 43) und einer auf der dem elektronischen Leistungsbauteil bzw. dem zu kühlenden Fluid abgewandten Seite der Kühlplatte (6, 43) angeordneten, plattenartigen Verteilereinrichtung (54, 4') für ein Kühlfluid, die auf ihrer der Kühlplatte (6, 43) zugekehrten Seite eine Vielzahl von ersten Austrittsöffnungen (9) für das Kühlfluid, die in einem Abstand von der Kühlplatte (6, 43) angeordnet und auf diese gerichtet sind und wenigstens eine erste Abführöffnung (10) für das Kühlfluid aufweist, wobei die Verteilereinrichtung (54, 4') eine erste Platte (1, 71), in der die ersten Austrittsöffnungen (9) und eine Vielzahl von ersten Abführöffnungen (10) gleichmäßig verteilt sind, eine zweite Platte (2, 72), in der eine Vielzahl von zweiten Abführöffnungen (56) verteilt sind, und eine dritte Platte (3, 53, 73) aufweist, wobei die erste, zweite und dritte Platte übereinander angeordnet sind, wobei die zweite Platte (2) zwischen der ersten Platte (1) und der dritten Platte (3) angeordnet ist, wobei die erste Platte (1, 71) und die zweite Platte (2, 72) einen mit allen ersten Austrittsöffnungen (9) verbundenen Zuführkanal (13) begrenzen und die zweite Platte (2, 72) und die dritte Platte (3, 53, 73) einen mit allen ersten Abführöffnungen (10) verbundenen Abführkanal (12) begrenzen, und wobei die Verteilereinrichtung (4) Leitungen (56, 82, 96) aufweist, die den Zuführkanal (13) durchqueren und die ersten Abführöffnungen (10) mit den zweiten Abführöffnungen (56) verbinden und wobei die ersten Austrittsöffnungen (9) direkt an den Zuführkanal (13) anschließen.

3. Kühlvorrichtung nach Anspruch 1 oder 2, **dadurch gekennzeichnet, daß** Leitungen (17, 96) einstückig mit der zweiten Platte (2) ausgebildet sind.

4. Kühlvorrichtung nach Anspruch 1, **dadurch gekennzeichnet, daß** die Leitungen (17) mit den Austrittsöffnungen (9) durch eine Steckverbindung verbunden sind.

5. Kühlvorrichtung nach Anspruch 2, **dadurch gekennzeichnet, dass** die Leitungen (55) einstückig mit der ersten Platte (1) ausgebildet sind.

6. Kühlvorrichtung nach Anspruch 5, **dadurch gekennzeichnet, daß** die Leitungen (55) durch eine Steckverbindung mit die zweite Platte (2) durchsetzenden Löchern (56) verbunden sind.

7. Kühlvorrichtung nach einem der Ansprüche 1 bis 6, **dadurch gekennzeichnet, daß** die erste Platte (1) in einer durch die Kühlplatte (6) abgedeckten Öffnung (20) einer Deckplatte (21) eines Gehäuses (22) eingesetzt, die zweite Platte (2) in einer Öffnung (23) einer Zwischenplatte (24) des Gehäuses (22) eingesetzt und die dritte Platte (3) durch eine Bodenplatte des Gehäuses (22) gebildet ist.

8. Kühlvorrichtung nach Anspruch 5 oder 6, **dadurch gekennzeichnet, daß** die dritte Platte (53) mit auf eine zweite Kühlplatte (61) gerichteten Austrittsöffnungen (59) versehen ist, die über den Abführkanal (12) und die zweite Platte (2) durchquerende Leitungen (58) mit dem Zuführkanal (13) verbunden sind, und daß die dritte Platte (53) zum Abführkanal (12) führende Abführöffnungen (63) aufweist.

9. Kühlvorrichtung nach einem der Ansprüche 1 bis 8, **dadurch gekennzeichnet, daß** jede Kühlplatte (6) aus Metall besteht und wenigstens die zweite Platte (2; 72) und die dritte Platte (3; 53; 73) sowie die Leitungen (17; 55; 58) aus wärmeisolierendem, thermoplastischen Kunststoff bestehen.

10. Kühlvorrichtung nach Anspruch 2, **dadurch gekennzeichnet, daß** zwischen der ersten Platte (71) und der zweiten Platte (72), an diesen anliegend, eine vierte Platte (74) angeordnet ist, in der ein etwa kammförmiger erster Durchbruch (76) den Zuführkanal (13) seitlich begrenzt, daß zwischen der zweiten Platte (72) und der dritten Platte (73), an diesen anliegend, eine fünfte Platte (75) angeordnet ist, in der ein etwa kammförmiger zweiter Durchbruch (77) den Abführkanal (12) seitlich begrenzt, daß jedem einer Kammzinke entsprechenden Zweig (78) des ersten Durchbruchs (76) wenigstens eine Gruppe (79) von Austrittsöffnungen (9) der ersten Platte (71) zugeordnet ist, daß jede zwischen benachbarte Zweige (78) des ersten Durchbruchs (76) ragende Zunge (80) der vierten Platte (74) eine Gruppe (81) von Abführöffnungen (82) aufweist, die jeweils mit einer Abführöffnung (10) in der ersten Platte (71) und einer Abführöffnung (83) in der zweiten Platte (72) fluchten, und daß jede Gruppe von Abführöffnungen (83) der zweiten Platte (72) jeweils einem einer Kammzinke entsprechenden Zweig (84) des zweiten Durchbruchs (77) zugeordnet ist.

11. Kühlvorrichtung nach Anspruch 10, **dadurch gekennzeichnet, daß** zwischen der Kühlplatte (6) und der ersten Platte (71), an diesen anliegend, eine sechste Platte (86) angeordnet ist, in der Löcher (87) ausgebildet sind, und daß über jedes dieser Löcher (87) jeweils wenigstens eine der Gruppen (79) von Austrittsöffnungen (9) und Abführöffnungen (10) der ersten Platte (71) mit der Kühlplatte (6) in Verbindung steht.

12. Kühlvorrichtung nach Anspruch 10 oder 11, **dadurch gekennzeichnet, daß** der erste Durchbruch (76) über in der zweiten, dritten und fünften Platte (72, 73, 75) ausgebildete, miteinander fluchtende Löcher (88-90) mit einem Einlaßanschluß und der zweite Durchbruch (77) über ein in der dritten Platte (73) ausgebildetes Loch (91) mit einem Auslaßanschluß verbunden ist.

13. Kühlvorrichtung nach einem der Ansprüche 10 bis 12, **dadurch gekennzeichnet, daß** die Platten dicht miteinander verbunden sind.

14. Kühlvorrichtung nach einem der Ansprüche 10 bis 13, **dadurch gekennzeichnet, daß** wenigstens die erste bis fünfte Platte (71-75) aus Kunststoff oder Metall bestehen und die Kühlplatte (6) aus Metall besteht.

## Claims

1. Cooling device for electronic power components (5, 45), with a heat conducting cooling plate (6, 43) that is in heat conducting contact with the electronic power component or a fluid to be cooled, respectively, during operation of the cooling device, and with a plate-like distribution device (4) for a cooling fluid arranged on the side of the cooling plate (6, 43) facing away from the electronic power component or the fluid to be cooled, respectively, said distribution device (4) having on its side facing the cooling plate (6, 43) a plurality of first outlet openings (9) for the cooling fluid, which are arranged at a distance from and directed towards the cooling plate (6, 43), and at least one discharge opening (10) for the cooling fluid; the distribution device (4) comprising a first plate (1) in which the first outlet openings (9) and a plurality of first discharge openings (10) are evenly distributed, a second plate (2), in which a plurality of second outlet openings (16) are distributed, and a third plate (3); the first, second and third plates being arranged on top of each other, the second plate (2) being arranged between the first plate (1) and the third plate (3); the second plate (2) and the third plate (3) defining a feed channel (13) connected to all first outlet openings (9) and the first plate (1) and the second plate (2) defining a discharge channel (12) connected to all first discharge openings (10), and the distribution device (4) comprising tubes (17), which cross through the discharge channel (12) and connect the second outlet openings (16) to the first outlet openings (9), the first discharge openings (10) ending directly in the discharge channel (12).

2. Cooling device for electronic power components (5, 45), with a heat conducting cooling plate (6, 43) that is in heat conducting contact with the electronic power component or a fluid to be cooled, respectively, during operation of the cooling device, and with a plate-like distribution device (54, 4') for a cooling fluid arranged on the side of the cooling plate (6, 43) facing away from the electronic power component or the fluid to be cooled, respectively, said distribution device (54, 4') having on its side facing the cooling plate (6, 43) a plurality of first outlet openings (9) for the cooling fluid, which are arranged at a distance from and directed towards the cooling plate (6, 43), and at least one discharge opening (10) for the cooling fluid; the distribution device (54, 4') comprising a first plate (1, 71) in which the first outlet openings (9) and a plurality of first discharge openings (10) are evenly distributed, a second plate (2, 72), in which a plurality of second discharge openings (56) are distributed, and a third plate (3, 53, 73); the first, second and third plates being arranged on top of each other, the second plate (2) being arranged between the first plate (1) and the third plate (3); the first plate (1, 71) and the second plate (2,72) defining a feed channel (13) connected to all first outlet openings (9) and the second plate (2, 72) and the third plate (3, 53, 73) defining a discharge channel (12) connected to all first discharge openings (10), and the distribution device (4) comprising tubes (56, 82, 96), which cross through the feed channel (13) and connect the first discharge openings (10) to the second discharge openings (56), the first outlet openings (9) being connected directly to the feed channel (13).

3. Cooling device according to claim 1 or 2, **characterised in that** the tubes (17, 96) are formed in one piece with the second plate (2).

4. Cooling device according to claim 1, **characterised in that** the tubes (17) are connected to the outlet openings (9) by plug connections.

5. Cooling device according to claim 2, **characterised in that** the tubes (55) are formed in one piece with the first plate (1).

6. Cooling device according to claim 5, **characterised in that** the tubes (55) are connected by a plug connection to holes (56) penetrating the second plate (2).

7. Cooling device according to any of the claims 1 to 6, **characterised in that** the first plate (1) is accommodated in an opening (20) in a cover plate (21) of a housing (22), the opening (20) being covered by the cooling plate (6); the second plate (2) is accommodated in an opening (23) in an intermediate plate (24) of the housing (22), and the third plate (3) is formed by a bottom plate of the housing (22).

8. Cooling device according to claim 5 or 6, **characterised in that** the third plate (53) is provided with outlet openings (59) directed to a second cooling plate (61), said outlet openings being connected to the feed channel (13) via the outlet channel (12) and tubes (58) crossing through the second plate (2), and that the third plate (53) has discharge openings (63) directed towards the discharge channel (12).

9. Cooling device according to one of the claims 1 to 8, **characterised in that** each cooling plate (6) is made of metal and at least the second plate (2; 72) and the third plate (3; 53; 73) as well as the tubes (17; 55, 58) are made from heat insulating thermoplastic plastic material.

10. A cooling device according to claim 1, **characterised in that** between the first plate (71) and the second plate (72) is arranged a fourth plate (74), which bears on the first and second plates (71, 72), an approximately comb-shaped first aperture (76) in said fourth plate (74) laterally defining the feed channel (13), that between the second plate (72) and the third plate (73) is arranged a fifth plate (75), which bears on the second plate (72) and third plate (73), an approximately comb-shaped second aperture in said fifth plate (75) laterally defining the discharge channel (12), at least a group (79) of outlet openings (9) of the first plate (71) being allocated to each branch (79), corresponding to a comb segment, of the first aperture (76), that each tongue (80) of the fourth plate (74) projecting between adjacent branches (78) of the first aperture (76) comprises a group (81) of discharge openings (82), each being in alignment with a discharge opening (10) in the first plate (71) and a discharge opening (83) in the second plate (72), and that a branch (84), corresponding to a comb segment, of the second aperture (77) is allocated to each group of discharge openings (83) of the second plate (72).

11. Cooling device according to claim 10, **characterised in that** between the cooling plate (6) and the first plate (71) is arranged a sixth plate (86) that bears on the cooling plate (6) and the first plate (71), holes (87) being formed in the plate (86), at least one of the groups (79) of outlet openings (9) and discharge openings (10) of the first plate (71) being connected to the cooling plate (6) via each of said holes (87).

12. Cooling device according to claim 10 or 11, **characterised in that** via holes (88-90) formed to be in alignment with one another in the second, third and fifth plates (72, 73, 75) the first aperture (76) is connected to an inlet connection, and the second aperture (77) is connected to an outlet connection via a hole (91) formed in the third plate (73).

13. Cooling device according to one of the claims 10 to 12, **characterised in that** the plates are sealingly connected to one another.

14. Cooling device according to one of the claims 10 to 13, **characterised in that** at least the first to fifth plates (71-75) are made of plastic or metal and that the cooling plate (6) is made of metal.

## Revendications

1. Dispositif de refroidissement pour des composants électroniques de puissance (5, 45), doté d'une plaque de refroidissement (6, 43) thermoconductrice en contact thermoconducteur avec le composant électronique de puissance en cas d'utilisation du dispositif de refroidissement, respectivement avec un fluide à refroidir, et doté d'un dispositif de distribution (4) pour un fluide de refroidissement de forme plate et disposé sur le côté de la plaque de refroidissement (6, 43) tourné vers le composant électronique de puissance respectivement vers le fluide à refroidir, lequel dispositif de distribution comprend sur son côté opposé à la plaque de refroidissement (6, 43) une pluralité de premiers orifices de sortie (9) pour le fluide de refroidissement, qui sont disposés à une distance de la plaque de refroidissement (6, 43) et dirigés vers cette dernière, et au moins un premier orifice d'évacuation (10) pour le fluide de refroidissement, le dispositif de distribution (4) comprenant une première plaque (1), dans laquelle sont répartis régulièrement les premiers orifices de sortie (9) et une pluralité de premiers orifices d'évacuation (10), une deuxième plaque (2), dans laquelle sont répartis une pluralité de seconds orifices de sortie (16), et une troisième plaque (3), les première, deuxième et troisième plaques étant disposées les unes au-dessus des autres, la deuxième plaque (2) étant disposée entre la première plaque (1) et la troisième plaque (3), la deuxième plaque (2) et la troisième plaque (3) limitant un canal d'amenée (13) relié à tous les premiers orifices de sortie (9) et la première plaque (1) et la deuxième plaque (2) limitant un canal d'évacuation (12) relié à tous les premiers orifices d'évacuation (10), et le dispositif de distribution (4) comportant des conduites (17) qui traversent le canal d'évacuation (12) et relient les deuxièmes orifices de sortie (16) aux premiers orifices de sortie (9), et les premiers orifices d'évacuation (10) débouchant directement dans le canal d'évacuation (12).

2. Dispositif de refroidissement pour des composants électroniques de puissance (5, 45), doté d'une plaque de refroidissement (6, 43) thermoconductrice en contact thermoconducteur avec le composant électronique de puissance en cas d'utilisation du dispositif de refroidissement, respectivement avec un fluide à refroidir, et doté d'un dispositif de distribution (54, 4') pour un fluide de refroidissement de forme plate et disposé sur le côté de la plaque de refroidissement (6, 43) tourné vers le composant électronique de puissance respectivement le fluide à refroidir, lequel dispositif de refroidissement comprend sur son côté opposé à la plaque de refroidissement (6, 43) une pluralité de premiers orifices de sortie (9) pour le fluide de refroidissement, qui sont disposés à une distance de la plaque de refroidissement (6, 43) et dirigés vers cette dernière, et au moins un premier orifice d'évacuation (10) pour le fluide de refroidissement, le dispositif de distribution (54, 4') comprenant une première plaque (1, 71), dans laquelle sont répartis régulièrement les premiers orifices de sortie (9) et une pluralité de premiers orifices d'évacuation (10), une deuxième plaque (2, 72), dans laquelle sont répartis une pluralité de deuxièmes orifices d'évacuation (56), et une troisième plaque (3, 53, 73), les première, deuxième et troisième plaques étant disposées les unes au-dessus des autres, la deuxième plaque (2) étant disposée entre la première plaque (1) et la troisième plaque (3), la première plaque (1, 71) et la deuxième plaque (2, 72) limitant un canal d'amenée (13) relié avec tous les premiers orifices de sortie (9), et la deuxième plaque (2, 72) et la troisième plaque (3, 53, 73) limitant un canal d'évacuation (12) relié à tous les premiers orifices d'évacuation (10), et le dispositif de distribution (4) comportant des conduites (56, 82, 96) qui traversent le canal d'amenée (13) et relient les premiers orifices d'évacuation (10) aux deuxièmes orifices d'évacuation (56) et les premiers orifices de sortie (9) sont directement contigus au canal d'amenée (13).

3. Dispositif de refroidissement selon la revendication 1 ou 2, **caractérisé en ce que** les conduites (17, 96) forment une seule pièce avec la deuxième plaque (2).

4. Dispositif de refroidissement selon la revendication 1, **caractérisé en ce que** les conduites (17) sont reliées aux orifices de sortie (9) par un raccord enfichable.

5. Dispositif de refroidissement selon la revendication 2, **caractérisé en ce que** les conduites (55) forment une seule pièce avec la première plaque (1).

6. Dispositif de refroidissement selon la revendication 5, **caractérisé en ce que** les conduites (55) sont reliées par un raccord enfichable à des trous (56) disséminés sur la deuxième plaque (2).

7. Dispositif de refroidissement selon l'une quelconque des revendications 1 à 6, **caractérisé en ce que** la première plaque (1) est logée dans une ouverture (20), recouverte par la plaque de refroidissement (6), d'une plaque de couverture (21) d'un boîtier (22), la deuxième plaque (2) est logée dans une ouverture (23) d'une plaque intermédiaire (24) du boîtier (22) et la troisième plaque (3) est formée par une plaque de fond du boîtier (22).

8. Dispositif de refroidissement selon la revendication 5 ou 6, **caractérisé en ce que** la troisième plaque (53) est pourvue d'orifices de sortie (59) dirigés vers une deuxième plaque de refroidissement (61), qui sont reliés au canal d'amenée (13) par le biais du canal d'évacuation (12) et de conduites (58) traversant la deuxième plaque (2), et **en ce que** la troisième plaque (53) comporte des orifices d'évacuation (63) menant au canal d'évacuation (12).

9. Dispositif de refroidissement selon l'une quelconque des revendications 1 à 8, **caractérisé en ce que** chaque plaque de refroidissement (6) est composée de métal et au moins la deuxième plaque (2 ; 72) et la troisième plaque (3 ; 53 ; 73) ainsi que les conduites (17 ; 55 ; 58) sont composées d'une matière synthétique thermo-isolante et thermoplastique.

10. Dispositif de refroidissement selon la revendication 2, **caractérisé en ce qu'**entre la première plaque (71) et la deuxième plaque (72) est disposée une quatrième plaque (74), adjacente à celles-ci, dans laquelle un premier passage (76) en forme à peu près de peigne limite latéralement le canal d'amenée (13), **en ce qu'**entre la deuxième plaque (72) et la troisième plaque (73) est disposée une cinquième plaque (75), adjacente à celles-ci, dans laquelle un deuxième passage (77) en forme à peu près de peigne limite latéralement le canal d'évacuation (12), **en ce qu'**au moins un groupe (79) d'orifices de sortie (9) de la première plaque (71) est affecté à chaque branche (78), correspondant à une dent de peigne, du premier passage (76), **en ce que** chaque languette (80) de la quatrième plaque (74) faisant saillie entre des branches voisines (78) du premier passage (76) comporte un groupe (81) d'orifices d'évacuation (82) qui sont alignés à chaque fois avec un orifice d'évacuation (10) dans la première plaque (71) et avec un orifice d'évacuation (83) dans la deuxième plaque (72), et **en ce que** chaque groupe d'orifices d'évacuation (83) de la deuxième plaque (72) est affecté à chaque fois à une branche (84), correspondant à une dent de peigne, du deuxième passage.

11. Dispositif de refroidissement selon la revendication 10, **caractérisé en ce que** entre la plaque de refroidissement (6) et la première plaque (71) est disposée une sixième plaque (86), adjacente à celles-ci, dans laquelle sont formés des trous (87) et **en ce qu'**au moins un des groupes (79) d'orifices de sortie (9) et d'orifices d'évacuation (10) de la première plaque (71) est à chaque fois en liaison avec la plaque de refroidissement (6) par le biais de chacun desdits trous (87).

12. Dispositif de refroidissement selon la revendication 10 ou 11, **caractérisé en ce que** le premier passage (76) est relié à un raccord d'entrée par le biais de trous (88 à 90) alignés entre eux et formés dans les deuxième, troisième et cinquième plaques (72, 73, 75) et **en ce que** le deuxième passage (77) est relié à un raccord de sortie par le biais d'un trou (91) formé dans la troisième plaque (73).

13. Dispositif de refroidissement selon l'une quelconque des revendications 10 à 12, **caractérisé en ce que** les plaques sont reliées entre elles tout étant étanches.

14. Dispositif de refroidissement selon l'une quelconque des revendications 10 à 13, **caractérisé en ce qu'**au moins les cinq premières plaques (71-75) sont composées de matière synthétique ou de métal et que la plaque de refroidissement (6) est composée de métal.
